# EUROPEAN PATENT SPECIFICATION

(11) **EP 2 669 739 B1**
(45) Date of publication and mention of the grant of the patent: **19.04.2023**
(21) Application number: 13168695.8
(22) Date of filing: 22.05.2013
(51) Int. Cl.: G03F 9/00

(54) **Measuring method, and exposure method and apparatus**
Messverfahren, und Belichtungsverfahren und Vorrichtung
Procédé de mesure et procédé et appareil d'exposition

(30) Priority: 30.05.2012 JP 2012123565
(43) Date of publication of application: 04.12.2013
(73) Proprietor: CANON KABUSHIKI KAISHA, Ohta-ku Tokyo 146-8501 (JP)
(72) Inventor: Maeda, Hironori, Ohta-ku Tokyo (JP); Egashira, Shinichi, Ohta-ku Tokyo (JP)
(74) Representative: Canon Europe Limited

(56) References cited:
- US-A1- 2006 023 214
- US-A1- 2009 115 987
- US-A1- 2011 033 790
- US-A1- 2012 307 226

## Description

### BACKGROUND OF THE INVENTION

### Field of the Invention

The present invention relates to a measuring method, and an exposure method and an apparatus.

### Description of the Related Art

In manufacturing devices, such as a semiconductor device, a liquid crystal display device, or a thin film magnetic head, etc., by using a photolithography technology, an exposure apparatus that projects pattern images of a photomask (reticle) onto a substrate (wafer, etc.) using a projection optical system and transfers patterns has been used. The exposure apparatus detects positions of marks on a wafer using a mark detection system within the exposure apparatus to carry out the positioning of the wafer and then projects the pattern images of the mask to accurately overlay patterns previously formed on the wafer to expose the wafer.

In recent years, in addition to IC chips such as a memory and a logic element, laminated devices such as a microelectromechanical system (MEMS) and a complementary metal-oxide semiconductor (CMOS) image sensor (contact image sensor (CIS)) using a through silicon VIA process have been manufactured using the exposure apparatus. In order to manufacture the above laminated devices, there is a process of detecting a position of an alignment mark formed on a back surface of the wafer to carry out the positioning and exposing a front surface of the wafer to patterns. Further, the through silicon VIA is formed from the front surface and conducted with the patterns on the back surface. For this reason, the overlaying of the patterns on the front surface and the patterns on the back surface is required to satisfy a predetermined precision requirement.

Japanese Patent Application Laid-Open No. 2011-40549 discusses the overlay inspection of marks on the front surface of the wafer and marks on the back surface of the wafer being carried out by detecting the front marks on the wafer with visible light and detecting the back marks on the wafer with infrared light. Specifically, both the front mark and the back mark are detected by irradiating the visible light and the infrared light onto the wafer and using: a dichroic mirror that separates the visible light and the infrared light from each other, a photoelectric conversion element that detects the visible light, and a photoelectric conversion element that detects the infrared light.

In Japanese Patent Application Laid-Open No. 2011-40549, when the wafer is irradiated with the visible light and the infrared light, the front surface mark is also irradiated with the infrared light and diffracted light or scattered light of the infrared light from the front surface mark is generated. When the light is focused on the back surface mark, the front surface mark becomes defocused so that the diffracted light or the scattered light of the infrared light from the front surface mark is incident on the photoelectric conversion element that detects the infrared light and degrades a contrast of an image of the back surface mark. Thus, the detection precision of the back surface mark is degraded. United States patent publication US2011033790A1 discloses a detection apparatus which detects an upper-surface mark and lower-surface mark formed on an upper surface and lower surface, respectively, of a substrate, the apparatus including an optical system configured to form an image of the lower-surface mark on a light-receiving surface of a photoelectric conversion device using a first light, with a wavelength which is transmitted through the substrate, which is emitted by a light source, applied to the lower-surface mark from the upper surface of the substrate, and reflected by the lower-surface mark, and to form an image of the upper-surface mark on the light-receiving surface of the photoelectric conversion device using a second light, with a wavelength which is not transmitted through the substrate, which is emitted by the light source, applied to the upper-surface mark from the upper surface of the substrate, and reflected by the upper-surface mark. United States patent publication US2006023214 discloses a method of measuring front to backside alignment error according to one embodiment, a transparent substrate has a plurality of marks on both the front and backside. The relative location of the marks on the front and backside of the substrate is determined to calculate the front to backside alignment error for the whole substrate. In a further embodiment, the substrate is rotated by 180 DEG within the plane of the substrate and the front relative location of the marks is again determined.

### SUMMARY OF THE INVENTION

It is desirable to detect a back surface mark of a substrate with high precision.

The present invention in its first aspect provides a measuring method as specified in claims 1 to 9 and claim 16.

The present invention in its second aspect provides an exposure method as specified in claim 10.

The present invention in its third aspect provides an exposure method as specified in claim 11.

The present invention in its fourth aspect provides a measuring apparatus as specified in claims 12 and 17.

The present invention in its fifth aspect provides a computer program as specified in claim 13.

The present invention in its sixth aspect provides an exposure apparatus as specified in claim 14.

The present invention in its seventh aspect provides a method for manufacturing a device as specified in claim 15.

Further features of the present invention will become apparent from the following description of exemplary embodiments with reference to the attached drawings.

### BRIEF DESCRIPTION OF THE DRAWINGS

Fig. 1 is a schematic diagram of an exposure apparatus.
Fig. 2 is a top view of a wafer and a wafer stage.
Fig. 3 is a schematic diagram of a wafer alignment detection system.
Figs. 4A, 4B, and 4C are diagrams for describing a problem of the related art.
Figs. 5A, 5B, 5C, and 5D are diagrams of a mark and a pattern on a wafer usable with the exemplary embodiment.
Figs. 6A, 6B, 6C and 6D are diagrams for describing a detection of the mark on the wafer according to the exemplary embodiment.
Figs. 7A and 7B are diagrams illustrating a detection sequence of the mark.
Figs. 8A and 8B are diagrams for describing a measurement error by a mirror.
Figs. 9A, 9B, 9C, 9D, 9E, 9F, and 9G are diagrams for describing the detection of the mark in a case where the wafer is at 0 degrees and 180 degrees.

### DESCRIPTION OF THE EMBODIMENTS

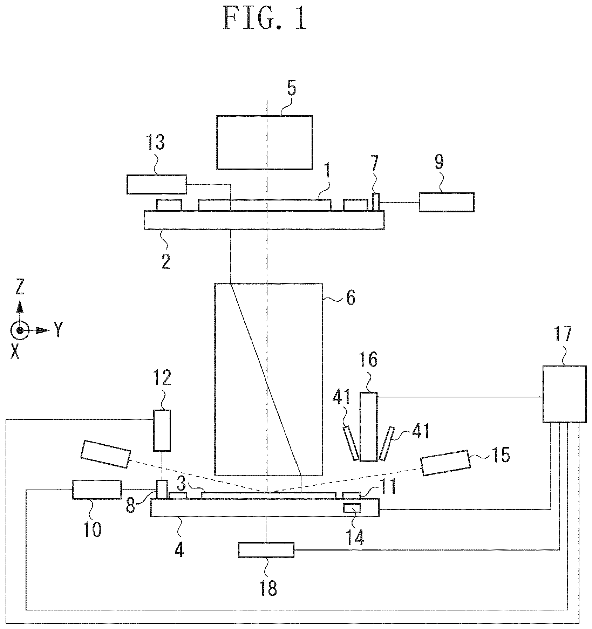

A measuring method and an exposure apparatus having a measuring device according to an exemplary embodiment will be described in detail with reference to the drawings. Fig. 1 is a schematic diagram of the exposure apparatus.

The exposure apparatus of Fig. 1 includes a reticle stage 2 that supports a reticle (mask) 1, and a wafer stage 4 that supports a wafer 3. In addition, the exposure apparatus includes an illumination optical system 5 that illuminates the reticle 1 with exposure light, a projection optical system 6 that projects pattern images of the reticle 1 illuminated with the exposure light onto the wafer 3, and a control device (not illustrated) that controls the entire operation of the exposure apparatus.

As the exposure apparatus, a case of using a scanning exposure apparatus (scanning stepper) that exposes the wafer 3 with the patterns of the reticle 1 while the reticle 1 and the wafer 3 move in a scanning direction in synchronization with each other will be described by way of example. However, an exposure apparatus (stepper) of a type in which the reticle 1 and the wafer 3 are stopped and the wafer 3 is exposed with the patterns of the reticle in a batch may also be used.

In the following description, a direction parallel with an optical axis of the projection optical system 6 is referred to as a Z-axis direction, a synchronous moving direction (scanning direction) of the reticle 1 and the wafer 3 within a plane perpendicular to the Z-axis direction is referred to as a Y-axis direction, and a direction (non-scanning direction) perpendicular to the Z-axis direction and the Y-axis direction is referred to as an X-axis direction. Further, the rotational directions around the X axis, the Y axis, and the Z axis are referred to as θX, θY, and θZ directions, respectively.

A predetermined illumination region on the reticle 1 is illuminated with the exposure light having a uniform illuminance distribution by the illumination optical system 5. As a light source of the exposure light emitted from the illumination optical system 5, a mercury lamp, a KrF excimer laser, an ArF excimer laser, an F2 laser, or an extreme ultra violet light source may be used.

The reticle stage 2, which is a stage that supports the reticle 1, can be two-dimensionally moved and can be slightly rotated in the θZ direction, within a plane perpendicular to the optical axis of the projection optical system 6, that is, within an XY plane. The reticle stage 2 may comprise at least one-axis driving or up to six-axis driving. The reticle stage 2 is driven by a reticle stage-driving device (not illustrated), such as a linear motor, and the like and the reticle stage driving device is controlled by the control device. A mirror 7 is provided on the reticle stage 2. In addition, a laser interferometer 9 is provided at a position facing the mirror 7 and irradiates the mirror 7 with a laser beam to measure a position in an XY direction of the mirror 7. A position and a rotation angle in a two-dimensional (XY) direction of the reticle 1 on the reticle stage 2 are measured in real time by the laser interferometer 9 and the measured results are output to the control device. The control device drives the reticle stage driving device based on the measured results of the laser interferometer 9 to perform the positioning of the reticle stage 2 (and thereby, of the reticle 1).

The projection optical system 6 is an optical system that projects the patterns of the reticle 1 onto the wafer 3 at a predetermined projection magnification β and is configured of a plurality of optical elements. In the exemplary embodiment, the projection optical system 6 is a reduction projection system of which the projection magnification β is, for example, 1/4 or 1/5.

The wafer stage 4 is a stage that supports the wafer 3 and includes a Z stage (i.e. a stage moveable in the z-direction) that holds the wafer 3 with a wafer chuck, an XY stage (moveable in the XY plane) that supports the Z stage, and a base that supports the XY stage. The wafer stage 4 is driven by a wafer stage driving system 18 such as a linear motor. The wafer stage driving system 18 is controlled by a control unit 17. The control unit 17 includes a computer in which programs for controlling the wafer stage 4 and/or an alignment detection system to be described below are installed.

Further, the mirror 8 moving along with the wafer stage 4 is provided on the wafer stage 4. In addition, laser interferometers 10 and 12 are provided at a position facing the mirror 8. The position in the XY direction and the θZ of the wafer stage 4 are measured by the laser interferometer 10. Further, the position in the Z direction and the θX and θY of the wafer stage 4 are measured by the laser interferometer 12. The measured results are output to the control unit 17. The position of the wafer 3 in an XYZ direction is adjusted by driving an XYZ stage through the wafer stage driving system 18 based on the measured result of the laser interferometers 10 and 12, and the positioning of the wafer 3 supported by the wafer stage 4 is performed.

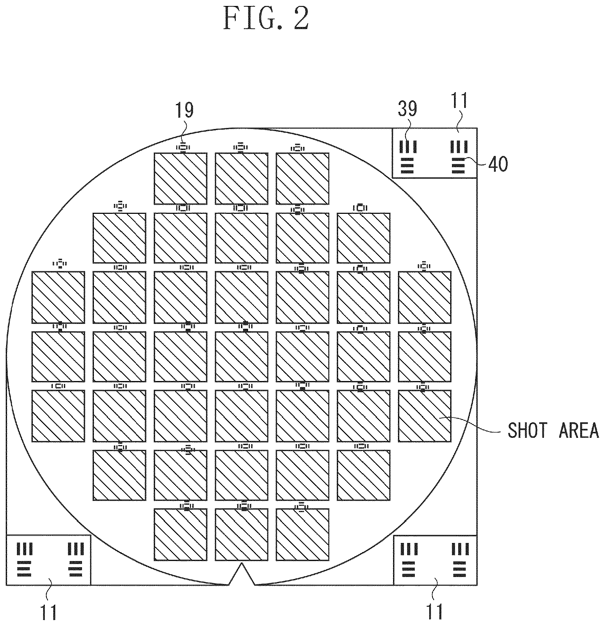

A detection system 13, which detects a reticle reference mark (not illustrated) on the reticle 1 and a reference mark 39 (see Fig. 2) on a stage reference plate 11 on the wafer stage 4 through the projection optical system 6, is provided in the vicinity of the reticle stage 2. The detection system 13 is equipped with a photoelectric conversion element that uses the same light source as the light source actually exposing the wafer 3 to irradiate the reticle reference mark on the reticle 1 and the reference mark 39 through the projection optical system 6 and then detects the reflected light. The positioning of the reticle 1 and the wafer 3 is performed based on the signal from the photoelectric conversion element. In this case, a position and a focus of the reticle reference mark and the reference mark 39 of the wafer stage reference plate 11 are adjusted, so that relative positions X, Y, and Z between the reticle and the wafer can be adjusted.

Further, the reference mark 39 of the wafer stage reference plate 11 may be a reflection type or a transmission type. In the case of the transmission type, the same light source as the light source exposing the wafer 3 and the illumination optical system 5 are used, the reticle reference mark and the transmissive reference mark 39 are irradiated through the projection optical system 6, and light passing through the transmissive reference mark 39 is detected using a light quantity sensor 14. In this case, the light quantity of the transmitted light is measured while the wafer stage 4 moves in at least one of the X, Y, and Z directions and at least one of the position and the focus of the reticle reference mark and the reference mark 39 of the wafer can be adjusted.

Fig. 2 is a top view of the wafer stage 4. The stage reference plate 11 at (at least) one corner of the wafer stage 4 includes the reference mark 39 to be detected by the detection system 13 and a reference mark 40 to be detected by a wafer alignment detection system (hereinafter, detection system) 16 and is disposed at substantially the same height as a surface of the wafer 3. As illustrated in Fig. 2, the stage reference plates 11 are arranged at multiple corners of the wafer stage 4, but one stage reference plate 11 may be provided and include plural pairs of reference marks 39 and 40. It is assumed that the position relationship (XY direction) between the reference mark 39 and the reference mark 40 is already known. Further, the reference mark 40 and the reference mark 39 may be one common mark. An alignment mark 19 is arranged in the vicinity of each shot area (hatched portion) on the wafer, that is, at a scribe line. By "shot area", what is meant is an area that is illuminated for exposure in order to create the final product. The area between each shot area is a scribe line along which the wafer will be cut when separating the product areas.

A focus detection system 15 includes a projection system that projects detection light onto the surface of the wafer 3 and a light receiving system that receives light reflected from the wafer 3 and detects the position in the Z-axis direction of the surface of the wafer 3. The detection results of the focus detection system 15 are output to the control device. The control device can drive the Z stage based on the detection results of the focus detection system 15 and adjust the position (focus position) and an incline angle in the Z-axis direction of the wafer 3 held by the 2 stage.

The detection system (detection optical system) 16 includes a projection system that projects detection light onto the alignment mark 19 on the wafer 3 or the reference mark 40 on the stage reference plate 11 and a light receiving system that receives light reflected from mark to detect the position of the mark in the XY direction. The detection results of the detection system 16 are output to the control unit 17. The control unit 17 drives the wafer stage 4 in the XY direction based on the detection results of the detection system 16 to perform the positioning in the XY direction of the wafer 3 held by the wafer stage 4.

Further, the detection system 16 is equipped with a focus detection system (AF detection system) 41 and similar to the focus detection system 15, includes a projection system that projects detection light onto the surface of the wafer 3 and a light receiving system that receives light reflected from the wafer 3. The focus detection system 15 is used for the best focusing of the projection optical system 6, while the AF detection system 41 is used for the best focusing of the detection system 16.

Forms of the wafer alignment detection system are classified into two types. The first form is an off-axis alignment (Off-axis AA) detection system (OA detection system) that is individually configured without including a projection optical system to optically detect an alignment mark on a wafer. The second form is a type of detecting an alignment mark on a wafer using a wavelength of a non-exposure light via a projection optical system. This type of alignment detection is called a through the lens alignment (TTL-AA) detection system. The present exemplary embodiment is described using the OA detection system, but is not limited thereto.

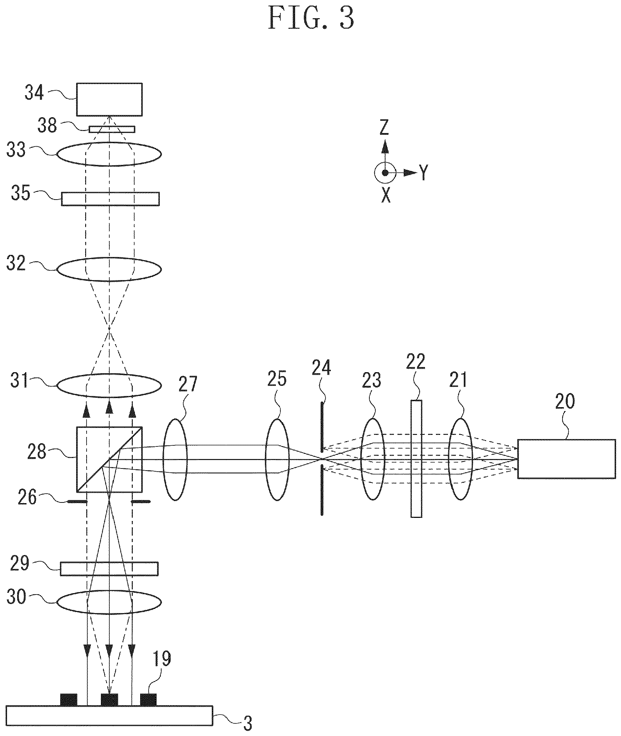

Fig. 3 is a diagram illustrating in detail the detection system 16. An illumination light source 20 is a light source that generates infrared light (for example, 1000 to 1500 nm) and visible light (for example, 400 to 800 nm). Light from the illumination light source 20 is guided by a fiber, and the light passes through a first relay optical system 21, a wavelength filter 22, and a second relay optical system 23 and reaches an aperture stop 24 at a position corresponding to a pupil surface (optical Fourier transform plane to an object surface) of the detection system 16. A beam diameter of the aperture stop 24 is set to be smaller than that of the illumination light source 20.

A wavelength filter 22 is provided with a plurality of filters having different transmission wavelength bands and it switches the filters in response to a command from the control device. Further, the aperture stop 24 is provided with a plurality of stops having different opening diameters and can change illumination σ by switching the aperture stop in response to the command from the control device.

The wavelength filter 22 and the aperture stop 24 are provided with a plurality of filters and stops in advance, but configured to be a mechanism in which new filters and stops may be added thereto. In the exemplary embodiment, the wavelength filter 22 may include a filter for visible light through which visible light is transmitted and a filter for infrared light through which infrared light is transmitted. The wavelength filter 22 thereby selects a wavelength of light to be guided to a specimen such as the wafer 3 or the reference plate 11.

The light reaching the aperture stop 24 is guided to a polarizing beam splitter 28 through optical systems 25 and 27. S-polarized light perpendicular to the page surface of Fig. 3 reflected by the polarizing beam splitter 28 passes through a NA (numerical aperture) stop 26 and a λ/4 plate 29 and is converted into circularly polarized light and illuminates the alignment mark 19 formed on the wafer 3 through an objective lens 30. The illumination light is represented by a solid line in Fig. 3. The NA of the illumination light may be changed by changing a stop amount (opening diameter) of the NA stop 26. The stop amount of the NA stop 26 can be changed by the command from the control device.

Reflected light, diffracted light, and scattered light (one dotted dashed line in Fig. 3) that are generated from the alignment mark 19 are converted into polarized light parallel to the paper surface through an objective lens 30 and the λ/4 plate 29 and pass through the NA stop 26 and the polarized beam splitter 28. Further, the image of the alignment mark 19 is formed on a photoelectric conversion element 34 by a relay lens 31, a first image forming optical system 32, a coma aberration adjusting optical member 35, a second image forming optical system 33, and a wavelength shift difference adjusting optical member 38.

Generally, in a case where a position is detected by observing the alignment mark 19 on the wafer 3 by the foregoing detection system 16, an interference fringe occurs in monochromatic light or light having a narrow wavelength band due to a transparent layer applied or formed above the mark. For this reason, the position may be detected in a state in which a signal of the interference fringe is added to a signal of the mark and therefore may not be detected with high precision. Therefore, as the illumination light source 20 of the detection system 16, an illumination light source having a broadband wavelength may be generally used, and the position is detected with a signal having a small interference fringe.

Next, the alignment on the back surface will be described. First, a circuit pattern and the alignment mark (second mark) for measuring an overlay deviation amount are exposed and thus formed on the wafer. Next, the wafer is turned over and the detection system 16 is used to detect the position of the alignment mark (second mark) from a front side as viewed from the detection system 16. Then, the detection of the position of the first surface is performed on a second mark (i.e. the back mark or lower-surface mark) or of the circuit pattern on the second surface (back surface viewed from the detection system 16) opposite the first surface, by using the detection results from the detection system 16. Next, the circuit pattern and the first mark (i.e. the front mark or upper-surface mark) for measuring the overlay deviation are exposed and thus formed on the first surface of the wafer. After the mark is formed, to inspect whether the overlay between the pattern on the front surface and the pattern on the back surface meets a predetermined precision, the overlay inspection of the front surface and the back surface of the wafer is performed by using the front mark and the back mark.

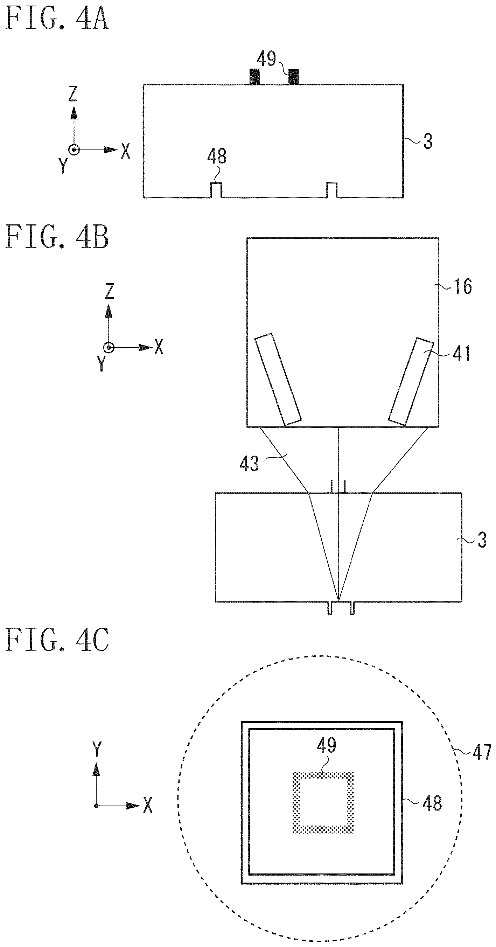

A problem in the overlay inspection of the front surface and the back surface of the wafer according to the related art will be described. Fig. 4A is a schematic cross-sectional view of the wafer 3 in which an inner mark 49 is formed on the front surface of the wafer and an outer mark 48 is formed on the back surface of the wafer. Fig. 4B illustrates a state in which the wafer is irradiated with an infrared light 43 to detect the outer mark 48. As illustrated in Fig. 4B, it can be appreciated that when the detection system 16 focuses on the outer mark 48, the detection system 16 does not focus on the front surface of the wafer. Fig. 4C illustrates an image obtained by observing the mark of Fig. 4A in the state of Fig. 4B. It can be appreciated that since the detection system 16 focuses on the back surface of the wafer, a contrast of an image of the outer mark 48 is relatively high, but the inner mark 49 on the front surface of the wafer is defocused and thus is blurred. Further, the contrast of the image of the outer mark 48 is degraded due to the effect of the defocus of the inner mark 49. The reason is that the inner mark 49 is irradiated with the light and the diffracted light or the scattered light from the inner mark 49 is generated.

As described above, at the time of intending to measure the outer mark 48 on the back surface of the wafer, the detection precision of outer mark 48 on the back surface of the wafer is degraded due to the effect of the defocused light of the inner mark 49 on the front surface of the wafer. Therefore, it can be appreciated that it is not recommendable to perform detection with both the outer mark 48 on the back surface of the wafer and the inner mark 49 on the front surface of the wafer being brought into a field of view 47 of the detection system 16 at the same time.

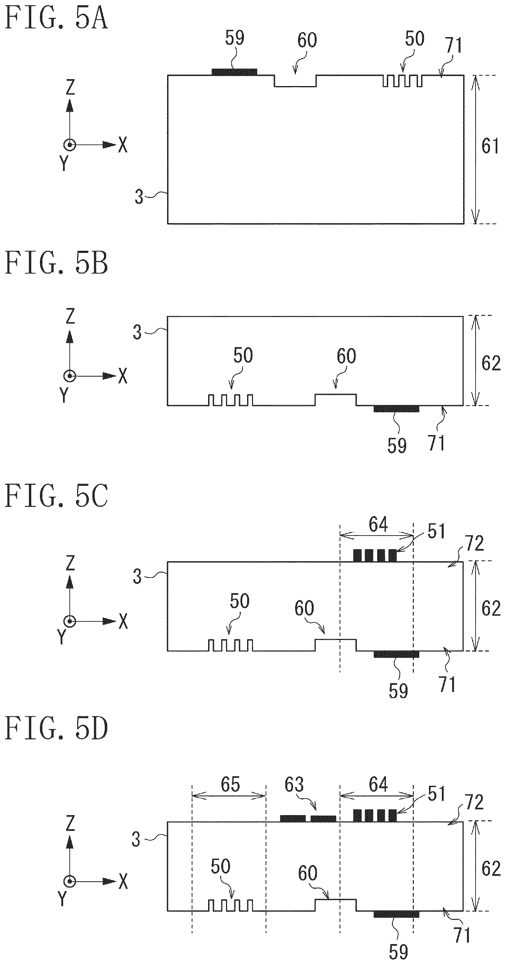

Next, in the exemplary embodiment, the measurement of the overlay deviation will be described. First, the marks and the circuit patterns on the front and back surfaces will be schematically described with reference to Figs. 5A to 5E. Fig. 5A is a diagram illustrating the state in which second circuit patterns 59 and 60 and a second mark 50 for measuring the deviation amount are formed on the second (back) surface 71 of the wafer 3. The mark or the patterns are formed by the exposure processing. A thickness 61 of the wafer in this state is, for example, about 775 um in a 12-inch wafer.

Fig. 5B is a diagram illustrating a state in which the wafer of which the second surface 71 in Fig. 5A is formed with the second circuit patterns 59 and 60 and the second mark 50 is turned over and is thinned. In Fig. 5B, the wafer is ground so that a thickness 62 of the wafer is, for example, 100 um, that is, thinner than that of Fig. 5A. The thickness 62 of the wafer illustrated in Fig. 5B is not limited to 100 um, and may be much thinner like 50 um, etc., or thicker like 150 um, etc., according to an eventual product.

Fig. 5C is a diagram illustrating a state in which for the thinned wafer 3 of Fig. 5B, a first surface 72 that is the front surface viewed from the detection system 16 is formed with the first mark (hereinafter, the front mark) 51 that is the alignment mark. The front mark 51 has a size to be included in a field of view 64 of the detection system 16. The second circuit patterns 59 and 60 on the second surface 71 (back surface) of Fig. 5C are immediately below the front mark 51 and it can be appreciated that when the front mark 51 is detected within the field of view 64 by the detection system 16, the second circuit patterns 59 and 60 are included in the field of view 64, although a height in the Z direction is different. When the front mark 51 is observed from the front surface using infrared light, since the infrared light passes through a Si wafer, the infrared light is simultaneously detected as noise components such as the reflected light, the diffracted light, and the scattered light from the second circuit patterns 59 and 60 on the lower surface of the front mark 51. When the light of noise components is incident from the second circuit patterns 59 and 60, the contrast of the front mark 51 is degraded, so that the measurement precision of the front mark 51 is degraded. For this reason, in the exemplary embodiment, the front mark 51 is detected with the visible light, not the infrared light. When the first mark 51 of Fig. 5C is measured with the visible light, since the visible light does not pass through the wafer 3, light does not reach the second circuit patterns 59 and 60 that are immediately below the front mark 51, so that the light of noise components is not generated. For this reason, the front mark 51 can be detected with high contrast and high precision.

Fig. 5D is a diagram illustrating a state in which a first circuit pattern 63 other than the front mark 51 is formed on the first surface 72 (front surface). In the first surface, the front mark 51 and the first circuit pattern 63 are not formed at a position facing the second mark (hereinafter, back mark) 50 on the second surface 71 (that is a back surface viewed from the detection system 16). The front mark 51 and the first circuit pattern 63 are arranged so that the back mark 50 is not within a field of view 65 in a case where the back mark 50 is detected from the front surface (first surface) by the detection system 16. That is, in the front surface of the wafer, the front mark and the pattern are formed on the front surface of the wafer so that the front mark and the pattern are not formed within a range having the same size as the field of view of the detection system 16 including the position facing the back mark. Therefore, in a case where the back mark 50 is detected by the detection system 16, there are no circuit pattern and front mark of the wafer 3, so that noise components, such as the reflected light, the diffracted light, and the scattered light from the pattern and the mark are not generated. For this reason, the back mark 50 can be detected with high contrast and high precision.

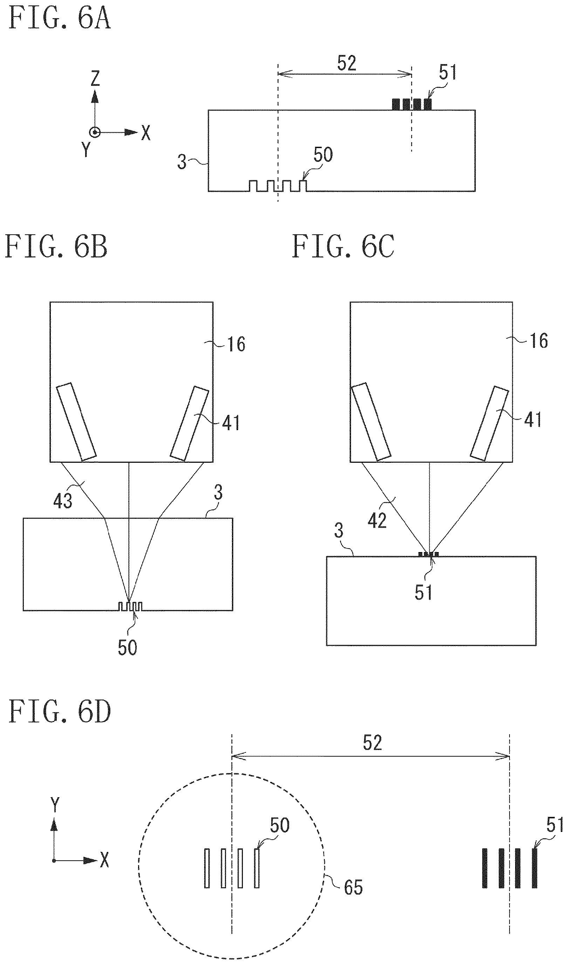

Next, a method for measuring (overlay deviation measurement) a relative position between the front mark and the back mark will be described with reference to Figs. 6A to 6D that are schematic diagrams. The method is executed by executing programs that are installed in a computer of the control unit 17 and allowing a computer to execute the control of the stage or the detection system.

Fig. 6A is a schematic diagram illustrating only the back mark 50 and the front mark 51 for convenience of explanation. The back mark 50 and the front mark 51 are formed so that their positions (coordinates) are separated by a separation 52 on a designed value in the X-direction. Figs. 6B and 6C are diagrams illustrating a state of the focus of the detection system 16. Fig. 6D is a diagram illustrating a plan view of the upper surface of the wafer including the back mark 50 and the front mark 51 and the field of view 65 of the detection system 16.

First, the control unit 17 controls the wafer stage 4 to move the wafer 3 so that the back mark 50 is within the field of view 65 of the detection system 16 and focuses the detection system 16 on the back surface of the wafer (via the front surface) as illustrated in Fig. 6B. In this case, as illustrated in Fig. 6D, the front mark 51 is arranged to be outside of the field of view 65 when the back mark 50 is detected by the detection system 16 to prevent the front mark 51 from being within the field of view. The detection system 16 then irradiates the back mark 50 with the infrared light 43 passing through the wafer from the front surface side to detect the image of the back mark 50 (first process). The position of the mark is detected using the laser interferometer 10. The control unit 17 obtains the detection results from the detection system 16 and the laser interferometer 10 and obtains the position of the back mark. In addition, to prevent both the back mark 50 and the front mark 51 from being within the field of view of the detection system 16, the separation 52 between the back mark 50 and the front mark 51 in the X-direction is ideally equal to or more than a half of the size (diameter) of the field of view.

Next, the wafer stage 4 is driven in the X direction a distance according to separation 52 and the front mark 51 is controlled to be within the field of view 65 of the detection system 16. In addition, as illustrated in Fig. 6C, the detection system 16 is focused on the front surface of the wafer. The position of the wafer in the optical axis direction of the detection system 16 may be adjusted by the wafer stage and the focal position of the detection system 16 may be adjusted. The detection system 16 irradiates the front mark 51 with the light (visible light) 42, which does not pass through the wafer, to detect the image of the front mark 51 (second process). The control unit 17 obtains the detection results from the detection system 16 and the laser interferometer 10 and obtains the position of the front mark 51. As described above, the position in the optical axis direction (position in the Z direction of the wafer stage) of the detection system 16 or a detection wavelength is changed at the time of measuring the back mark 50 compared to the time of measuring the front mark 51.

The computer (calculation unit) of the control unit 17 uses the position of the back mark 50 and the position of the front mark 51, which are detected in this way, to perform subtraction between the positions, thereby calculating the relative position between the front mark 51 and the back mark 50. Further, the overlay deviation amount of the front mark 51 and the back mark 50 is calculated by obtaining the calculated relative position and the separation 52. Specifically, the overlay deviation amount = {(the detected positional value of the back mark 50) - (the detected positional value of the front mark 51)} - the separation 52. Thus, the position of the back mark 50 is detected with high precision to realize the overlay inspection with high precision. In addition, the calculated overlay deviation amount is reflected to the subsequent wafer alignment control to align the wafer and expose the wafer, thereby reducing the overlay deviation on the exposed wafer.

Further, the wafer stage 4 is moved so that the mark is arranged within the field of view by fixing the field of view of the detection system 16, but the field of view of the detection system 16 may be moved to allow the mark to be in the field of view. In addition, the size or shape of the field of view of the detection system 16 may be changed using a field stop. For example, in a case where the back mark 50 is detected by the detection system 16, the opening diameter of the field stop is set to be small, so that it is possible to set the size of the field of view to be small and prevent the front mark 51 from being within the field of view. Further, in a case where the back mark 50 is detected by the detection system 16, a light shielding plate may be arranged at any place of the detection system 16 to prevent the light from the front mark 51 from entering the photoelectric conversion element 34. Therefore, in a case where the back mark 50 is detected by the detection system 16, the noise components of the scattered light, and the like, from the front mark 51 may be reduced.

Since the front mark 51 uses wafer non-transmitted light and the back mark 50 uses wafer transmitted light, offsets occur for each observation wavelength of the front surface and the back surface. For this reason, the offsets occurring for each observation wavelength of the front surface and the back surface are obtained in advance and the detected value of the mark may be corrected with each offset. In connection with the offsets for each wavelength, for example, the reference mark 40 arranged on the stage reference plate 11 of Fig. 4 is measured with the wafer transmitted light and the wafer non-transmitted light and the wavelength difference offset is calculated. Thus, errors due to the shape of the mark, and the like, do not occur by using a common mark in the wafer transmitted light and the wafer non-transmitted light. Alternatively, a mark on the wafer may be irradiated and measured on the front surface and on the back surface of the wafer with radiation always coming from the same direction such that it has to pass through the wafer to reach the back surface. There may either be identical marks on the front and back surfaces or the wafer may be turned over so that the wafer may be irradiated and measured with the mark both on the front and back surfaces. Light with different wavelengths is used for both of these so a wavelength difference offset can be determined by using this single or identical mark.

Further, the marks 50 and 51 may be not a dedicated mark for inspecting the overlay, but may be an alignment mark that doubles as the alignment mark for aligning and exposing the wafer (shot area). In the overlay inspection according to the related art, as illustrated in Figs. 4A and 4C, a box-in-box type mark used only for the overlay inspection has been used. In the exemplary embodiment, like the marks 50 and 51 illustrated in Fig. 6D, a general wafer alignment mark of a four-line type, and the like, is used. Therefore, the wafer alignment mark used for the positioning of the general wafer exposure and the mark of the overlay inspection may be common to avoid the effect of the mark difference and realize the overlay inspection with high precision. Further, the marks 50 and 51 may have different shapes or the same shape. In addition, the marks 50 and 51 are described as having the separation in the X direction, but may be described as having the separation in the Y direction.

Further, to measure the overlay deviation, an alignment mark corresponding to at least some of the plurality of shot areas on the wafer may be detected. In this case, the marks on the back surface of the wafer are measured as much as the plurality of shot areas without changing the position of the wafer in the Z direction (the position in the optical axis direction of the alignment detection system). Next, the detection system 16 is focused on the front surface of the wafer by driving the wafer stage in the Z direction and the marks on the front surface of the wafer may be measured as often as the plurality of shot areas without changing the position of the wafer in the Z direction. Therefore, the number of driving times of the wafer stage in the Z direction is once and as compared with in the case where the wafer stage is driven in the Z direction for each measurement of the back mark and the front mark for one shot area, the mark may be measured in a short time and the throughput is improved.

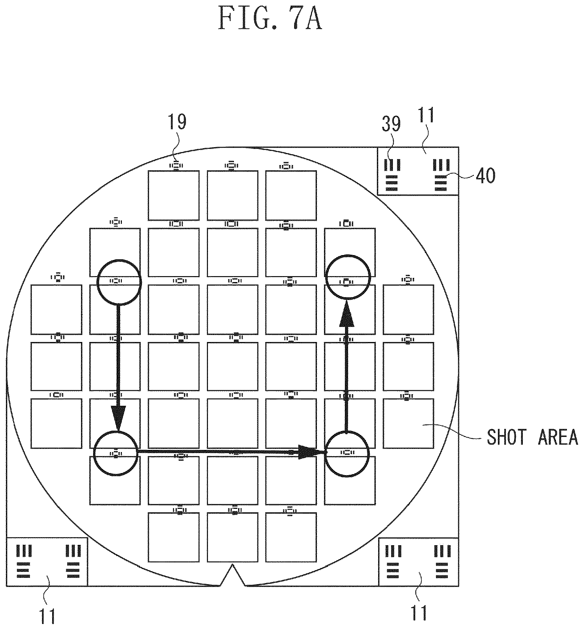

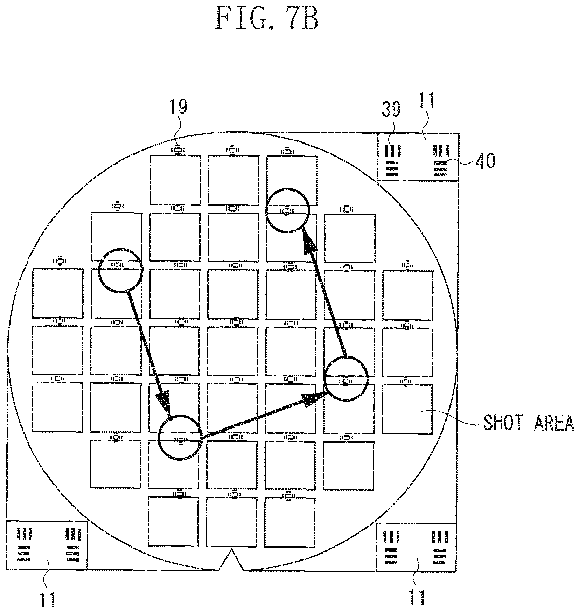

By way of example, an overlay measuring sequence with 4 shot area will be described with reference to Figs. 7A and 7B. Fig. 7A illustrates a sequence of the shot area measuring the alignment mark, in which four places of the alignment mark encircled are measured in a sequence shown by arrows (→). First, the back mark on the wafer undergoes the measurement of four shot area in a sequence shown by arrows illustrated in Fig. 7A. When the measurement of the four shot area ends, the wafer stage is driven in the Z direction and the detection system 16 is focused on the front mark of the wafer. The front mark of the wafer is then measured in a sequence of the shot area of Fig. 7A. Thus, the detection sequence of the back mark of the wafer and the detection sequence of the mark on the front mark on the wafer are identical (common), thereby reducing the errors due to a difference in a step direction. For example, if the detection sequence of the back mark on the wafer is as shown in Fig. 7A but the detection sequence of the mark on the front mark on the wafer is as illustrated in Fig. 7B, an error occurs due to the difference in the step direction, which becomes the error of the overlay measurement of the back mark and the front mark on the wafer. In addition, the mark is indicated in the detection sequence with the four shot area but the overlay inspection may perform all shot measurements. Further, in the foregoing description, the back mark on the wafer is first measured and the front mark on the wafer is detected later, but the front mark on the wafer may be first detected and the back mark on the wafer may be detected later.

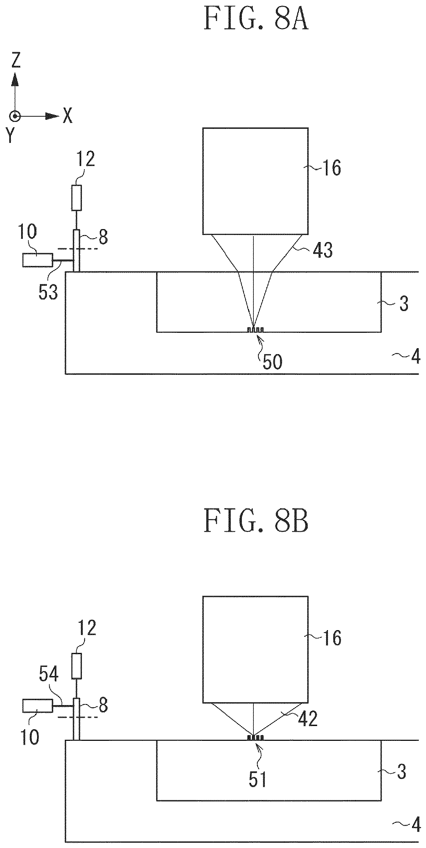

Further, the stage correction data that may be different for each Z position of the wafer stage may be used and the detection position of the mark or the position of the wafer stage may be corrected. Figs. 8A and 8B are diagrams illustrating how a laser beam from the laser interferometer 10 reaches the mirror 8 when the back mark 50 and the front mark 51 on the wafer 3 are detected by the detection system 16. The interferometer 10 is independent of the wafer stage 4, whereas the mirror 8 is on the wafer stage 4 such that a movement of the wafer stage 4 in the Z direction moves the mirror relative to the interferometer 10. This enables the interferometer 10 to measure a change in height in the Z direction of the wafer stage and thereby of the wafer 3, but more importantly, it enables the interferometer 10 to determine whether there is any unintentional movement of the wafer stage in the X and Y directions while the wafer stage is being moved intentionally in the Z direction. Fig. 8A is a diagram illustrating a case where the back mark 50 is detected with the infrared light 43, in a state where the detection system 16 is focused on the back mark 50. In this case, a laser beam 53 from the laser interferometer 10 reaches a portion that is below (i.e. closer to the wafer stage 4 than) a center (dashed line in Fig. 8A) of the mirror 8 on the wafer stage 4. Fig. 8B is a diagram illustrating the case where the front mark 51 is measured with the visible light 42, in a state where the detection system 16 is focused on the front mark 51. In this case, a laser beam 54 from the laser interferometer 10 is incident on a portion that is above a center of the mirror 8. That is, the position of the laser beam incident on the mirror 8 is different when measuring the back mark 50 from the position when measuring the front mark 51.

Although the mirror 8 is made of a material with minimal deformation, a detection error may occur depending on the change in the positions of the laser beam incident on the mirror 8 due to irregularity of a reflection surface of the mirror, a deviation in planarity thereof, and the like. For example, in Fig. 8, the detection error of the position in the Y direction occurs due to the laser interferometer 10. For this reason, during a set-up process, the wafer stage moves in the Z direction to allow the laser interferometer 10 to perform the measurement to preliminarily create the correction data of the detected value of the position in the Y direction according to the position of the wafer stage in the Z direction. Further, the detection results by the laser interferometer 10 are corrected (calibrated) using the correction data. In addition, the wafer stage may be driven using the correction data to adjust the alignment of the wafer 3. Therefore, the position of the mark can be obtained with high precision and the wafer stage can also be controlled with high precision. Further, the positions of the laser beam reaching the mirror 8 are not limited to the foregoing example, and for example, in the measurement of the back surface of the wafer and the measurement of the front surface of the wafer, a case where both the positions of the laser beam reaching the mirror 8 on the wafer stage are at a lower half part from the center of the mirror may be applied.

Further, at the time of measuring the back mark 50 and the front mark 51, the deviation in the X direction or the Y direction occurring by the driving of the wafer stage in the Z direction may also be reduced by performing the measurement in two states in which the wafer is at 0 degrees and 180 degrees.

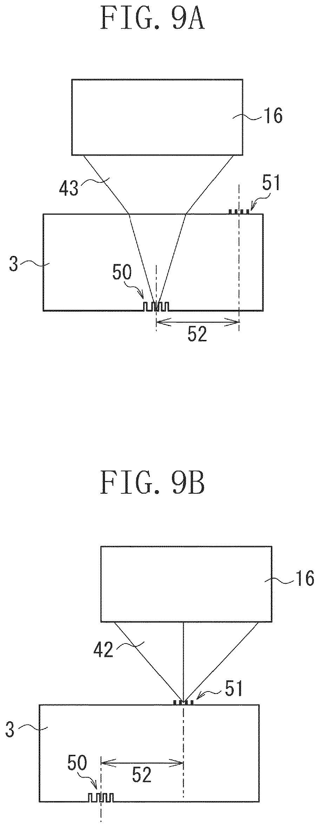

Figs. 9A and 9B illustrate a state in which there are the back mark 50 and the front mark 51 spaced apart from each other by the separation distance 52 and the detection system 16 is focused on each mark and performs the measurement. The angle of the wafer in this state is defined as 0 degrees.

In this case, the overlay deviation amount of the back mark 50 and the front mark 51 becomes a value obtained by calculating the difference between the measured value of the back mark 50 of Fig. 9A and the measured value of the front mark 51 of Fig. 9B and subtracting the separation 52 from the calculated difference. If the overlay deviation amount calculated from Figs. 9A and 9B is set to be OvD-0, the overlay deviation amount (OvD-0) measured at the wafer at 0 degrees is equal to {(the detected positional value of the back mark 50) - (the detected positional value of the front mark 51)} - separation 52. Here, the separation 52 is calculated as the position of the back mark 50 - the position of the front mark 51 when the wafer is at 0 degrees.

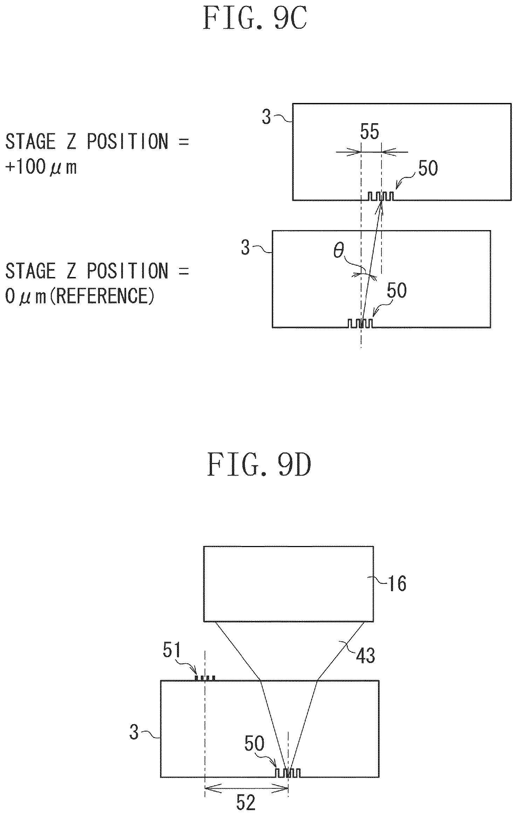

The overlay deviation amount is affected by the detection error in the mark position that occurs due to the driving of the wafer stage in the Z direction. Fig. 9C is a diagram for describing a deviation amount 55 of the wafer stage 4 in the Y direction, which occurs due to the wafer stage 2 driving. For example, it is assumed that the wafer stage is driven by + 100 um from the 2 position (0 µm) that becomes a reference. In this case, ideally, it is advantageous that the back mark 50 only moves upwardly and the position deviation of the back mark 50 in the Y direction does not occur, but actually, the position deviation occurs as much as the deviation amount 55 that occurs due to the stage 2 driving. This occurs because the wafer stage is driven in the Z direction with a slight inclination θ. In a case where the overlay of the front and back surfaces of the wafer is inspected, the Z driving amount of the wafer stage is a large amount like 100 um, and the like, as illustrated in Fig. 9C, so that even if the inclination θ is a small amount, the deviation amount 55 occurring due to the stage 2 driving is increased. For example, even when the inclination θ is a small amount like 1 mrad, a very large deviation amount like 1 mrad * 100 um = 100 nm occurs. That is, the calculated overlay deviation amount (OvD-0) includes a "true" overlay deviation amount and the deviation amount 55 that occurs due to the stage 2 driving. Represented by the following Equation, the overlay deviation amount (OvD-0) measured at the wafer at 0 degrees = the true overlay deviation amount + the deviation amount 55 occurring due to the stage Z driving.

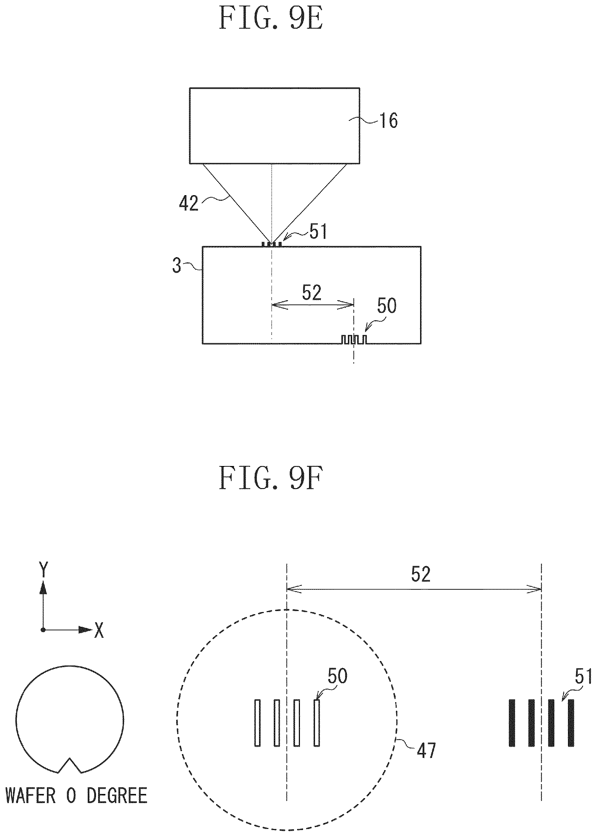

Figs. 9D and 9E are diagrams illustrating a state of the wafer in a case where the wafer in the state of Figs. 9A and 9B is rotated by 180 degrees around an axis of a normal direction of a wafer surface (also known as a substrate surface) as a rotation axis. Thus, an overlay deviation quantity (OvD-180) is calculated by detecting the back mark 50 and the front mark 51 at each focus position in a state where the wafer has been rotated by 180 degrees. Represented by the following Equation, the overlay deviation amount (OvD-180) measured at the wafer at 180 degrees = {(the detected positional value of the back mark 50) - (the detected positional value of the front mark 51} - separation 52. Here, the separation 52 is also calculated as the position of the back mark 50 - the position of the front mark 51 when the wafer is at 180 degrees.

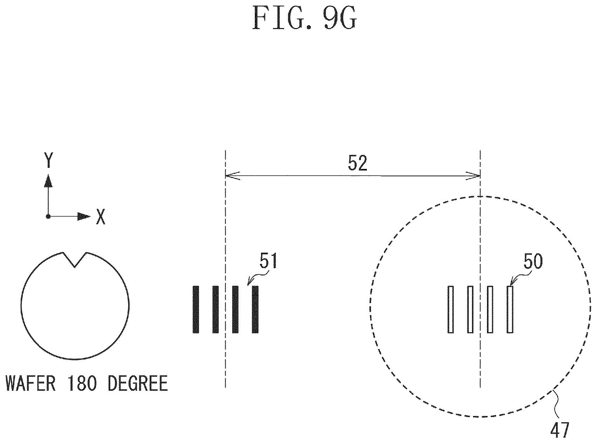

Since the wafer is measured in the state where the wafer has been rotated by 180 degrees, the overlay deviation amount has an inverted sign compared to in the case where the wafer is at 0 degrees. Figs. 9F and 9G are diagrams illustrating a plan view of the marks 50 and 51 in an XY coordinate system when the back mark 50 and the front mark 51 are observed in the state in which the wafer is at 0 degrees and at 180 degrees. Fig. 9F illustrates the mark observation in a state where the wafer illustrated in Figs. 9A and 9B is at 0 degrees in the XY coordinate system, and Fig. 9G illustrates the mark observation in a state where the wafer illustrated in Figs. 9D and 9E has been rotated by 180 degrees in the XY coordinate system. In the calculation of the overlay deviation amount (OvD-0) when the wafer is at 0 degrees, since the measured value of the front mark 51 is large, it can be appreciated from Fig. 9F that (the measured positional value of the back mark 50) - (the measured positional value of the front mark 51) is negative. In the calculation of the overlay deviation quantity (OvD-180) when the wafer is at 180 degrees, since the measured value of the back mark 50 is large, it can be appreciated from Fig. 9G that (the measured positional value of the back mark 50) - (the measured positional value of the front mark 51) is positive. The same applies to the true overlay deviation amount.

The overlay deviation amount (OvD-180) includes the position deviation amount 55 occurring due to the stage 2 driving illustrated in Fig. 9C. Represented by the following Equation, the overlay deviation amount (OvD-180) measured at the wafer at 180 degrees = the true overlay deviation amount + the deviation amount 55 occurring due to the stage 2 driving. The true overlay deviation amounts when the wafer is at 0 degrees and 180 degrees are inverted in sign with respect to each other and the deviation amounts 55 occurring due to the stage 2 driving have the same sign as each other because the orientation of the wafer does not affect the drift in the X-Y plane during movement of the wafer stage 4 in the Z-direction. For this reason, the true overlay deviation amount may be calculated by performing an operation that divides in half the difference between the OvD-0 and OvD-180 calculated in the state where the wafer is at 0 degrees and 180 degrees. Represented by the following Equation, the true overlay deviation amount = |(overlay deviation amount (OvD-0) - overlay deviation amount (OvD-180))/2|. Therefore, it is possible to cancel the deviation amount 55 occurring due to the stage Z driving included in the OvD-0 and OvD-180 and to realize the high-precision overlay inspection that does not include the error due to the stage Z driving.

Further, the case where the substrate is a Silicon wafer has been described, but the substrate is not limited thereto. For example, a substrate made of silicon carbide (SiC) or dopant Si, and the like, may be used. In addition, the wafer alignment detection system may be arranged above or below the wafer.

Next, a method for manufacturing a device (liquid crystal device, and the like) using the exposure apparatus according to the exemplary embodiment will be described. A liquid crystal display device is manufactured by a process of forming a transparent electrode. The process of forming a transparent electrode includes applying a photosensitizer to a glass substrate on which a transparent conductive layer is deposited, exposing the glass substrate to which the photosensitizer is applied using the foregoing exposure apparatus, and developing the glass substrate.

The method for manufacturing a device using the foregoing exposure apparatus is suitable for the manufacturing of devices such as a semiconductor device and the like, in addition to the liquid crystal display device. The method may include exposing the substrate applied with the photosensitizer using the exposure apparatus and developing the exposed substrate. Further, the method for manufacturing a device may include other known processes (oxidation, film formation, deposition, doping, planarization, etching, resist delamination, dicing, bonding, packaging, and the like).

While the present invention has been described with reference to exemplary embodiments, it is to be understood that the invention is not limited to the disclosed exemplary embodiments.

## Claims

1. A measuring method for measuring a relative position of a first mark (51) formed on a first surface of a substrate (3) and a second mark (50) formed on a second surface opposite the first surface of the substrate by using a detection optical system (16) that illuminates a mark formed on the substrate to detect an image of the mark, the method comprising:
performing a first processing to detect an image of the first mark (51) by using the detection optical system (16) to illuminate the first mark from the first surface side of the substrate in a state where the first mark is within a field of view (65, 47) of the detection optical system;
changing a relative position of the detection optical system in a direction perpendicular to an optical axis direction of the detection optical system and the substrate for a distance equal to or more than a half of a diameter of the field of view of the detection optical system, so that the first mark is arranged outside of the field of view of the detection optical system and the second mark is arranged within the field of view of the detection optical system;
performing a second processing to detect an image of the second mark (50) by using the detection optical system to illuminate the second mark from the first surface side of the substrate with light (43) having a wavelength passing through the substrate in a state where the first mark (51) is out of the field of view of the detection optical system and the second mark (50) is within the field of view of the detection optical system; and
calculating the relative position of the first mark and the second mark by using detection results of the first processing and the second processing.

2. The measuring method according to claim 1, wherein, in the second processing, a product pattern (59, 60) and the first mark (51) which are on the first surface are outside the field of view (65, 47) of the detection optical system (16).

3. The measuring method according to claim 1 or 2, wherein a position of the substrate (3) in the optical axis direction of the detection optical system (16) is changed between the first processing and the second processing so that the detection optical system (16) is focused on the first mark (51) in the first processing and the detection optical system is focused on the second mark (50) in the second processing.

4. The measuring method according to claim 1, 2 or 3, wherein the first processing and the second processing are performed when a rotation angle of the substrate (3) is 0 degrees and 180 degrees respectively around an axis of a normal direction of the substrate surface as a rotation axis.

5. The measuring method according to any one of claims 1 to 4, further comprising:
in the first processing and the second processing, detecting the relative position of the respective marks (50, 51) using an interferometer (10) that enables light to be incident on a mirror (8) provided on a stage (4) that moves the substrate (3); and
obtaining correction data for correcting a detection error of the relative position of the marks (50, 51) occurring due to a change in a position of the light incident on the mirror.

6. The measuring method according to any one of claims 1 to 5, further comprising obtaining offsets that occur for respective wavelengths of light having a first wavelength that does not pass through the substrate (3)used for detecting the first mark and light having a second wavelength passing through the substrate used for detecting the second mark; and
correcting a detection error of the position of the marks based on the wavelength difference offset.

7. The measuring method according to claim 6, wherein the offsets for the respective wavelengths are obtained by illuminating a same mark, or two identical marks, on the first surface with the light having the first wavelength and on the second surface with the light having the second wavelength.

8. The measuring method according to claim 3,
wherein, in the first processing, images of a plurality of first marks (19) corresponding to a plurality of shots formed on the first surface of the substrate are detected without changing the position of the substrate in the optical axis direction (Z) of the detection optical system, and
wherein, in the second processing, images of a plurality of second marks corresponding to a plurality of shots formed on the second surface of the substrate are detected without changing the position of the substrate in the optical axis direction (Z) of the detection optical system.

9. The measuring method according to claim 8, wherein a detection sequence of the plurality of first marks (19) is the same as a detection sequence of the plurality of second marks.

10. An exposure method for creating marks on a substrate (3), the method comprising:
providing a substrate comprising a first surface and a second surface opposite to the first surface, the substrate comprising a second mark formed on the second surface;
using an exposure system comprising a detection optical system to expose and form, on the first surface of the substrate (3), a first mark (51) and a pattern (49, 50) at a position on the substrate outside of a field of view of the detection optical system including a position opposite the second mark; and
executing a measurement method according to any one of the preceding claims after the exposing and forming.

11. An exposure method comprising:
calculating the relative position of the first mark (51) and the second mark (50) using the measuring method according to any one of claims 1 to 9;
calculating an amount of overlay deviation of the first mark and the second mark using a separation between the first mark and the second mark and the calculated relative position; and
performing an alignment of the substrate (3) by using the calculated amount of overlay deviation.

12. A measuring apparatus for measuring a relative position between a first mark (51) formed on a first surface of a substrate (3) and a second mark (50) formed on a second surface opposite the first surface of the substrate, the measuring apparatus comprising:
a detection optical system (16) configured to illuminate the mark formed on the substrate to detect an image of the mark; and
calculation means configured to perform a calculation using detection results from the detection optical system,
wherein the detection optical system (16) is configured:
to illuminate the first mark (51) from the first surface side of the substrate (3) to detect the image of the first mark in a state where the first mark is within a field of view (65, 47) of the detection optical system, and
to detect an image of the second mark (50) by illuminating the second mark from the first surface side of the substrate with light having a wavelength passing through the substrate (3) by using the detection optical system, after changing a relative position of the detection optical system in a direction perpendicular to an optical axis direction of the detection optical system and the substrate for a distance equal to or more than a half of a diameter of the field of view of the detection optical system, and
wherein the calculation means is configured to calculate the relative position between the first mark and the second mark by using detection results from the detection optical system.

13. A computer program comprising instructions to cause the apparatus of claim 12 to perform the method of any of claims 1 to 9.

14. An exposure apparatus for exposing a substrate comprising the measuring apparatus according to claim 12, wherein the exposure apparatus is configured to perform an alignment of the substrate by using a relative position, calculated by the measuring apparatus, between the first mark (51) and the second mark (50).

15. A method for manufacturing a device, comprising:
exposing a substrate (3) using the exposure apparatus according to claim 14; and
developing the exposed substrate.

16. A measuring method for measuring a relative position of a first mark formed on a first surface of a substrate and a second mark formed on a second surface opposite the first surface of the substrate by using a detection optical system that illuminates a mark formed on the substrate to detect an image of the mark, the method comprising:
performing a first processing to detect an image of the second mark by using the detection optical system to illuminate the second mark from the first surface side of the substrate, with light having a wavelength passing through the substrate in a state where the second mark is arranged within a field of view of the detection optical system;
changing a relative position of the detection optical system in a direction perpendicular to an optical axis direction of the detection optical system and the substrate for a distance equal to or more than a half of a diameter of the field of view of the detection optical system, so that the second mark is arranged outside of the field of view of the detection optical system and the first mark is arranged within the field of view of the detection optical system;
performing a second processing to detect an image of the first mark by using the detection optical system to illuminate the first mark from the first surface side of the substrate with light in a state where the second mark is arranged outside of the field of view of the detection optical system and the first mark is arranged within the field of view of the detection optical system; and
calculating the relative position of the first mark and the second mark by using detection results of the first processing and the second processing.

17. A measuring apparatus for measuring a relative position between a first mark formed on a first surface of a substrate and a second mark formed on a second surface opposite the first surface of the substrate, the measuring apparatus comprising:
a detection optical system configured to illuminate the mark formed on the substrate to detect an image of the mark; and
calculation means configured to perform a calculation using detection results from the detection optical system,
wherein the detection optical system is configured:
to detect an image of the second mark by illuminating the second mark, from the first surface side of the substrate, with light having a wavelength passing through the substrate by using the detection optical system, in a state where the second mark is arranged within a field of view of the detection optical system; and
to detect an image of the first mark by illuminating the first mark with light, from the first surface side of the substrate, in a state where a relative position of the detection optical system in a direction perpendicular to an optical axis direction of the detection optical system and the substrate is changed for a distance equal to or more than a half of a diameter of the field of view of the detection optical system, so that the second mark is arranged outside of the field of view of the detection optical system and the first mark is arranged within the field of view of the detection optical system, and
wherein the calculation means is configured to calculate the relative position between the first mark and the second mark by using detection results from the detection optical system.

## Patentansprüche

1. Messverfahren zum Messen einer Relativposition einer auf einer ersten Oberfläche eines Substrats (3) gebildeten ersten Markierung (51) und einer auf einer zweiten Oberfläche gegenüber der ersten Oberfläche des Substrats gebildeten zweiten Markierung (50) unter Verwendung eines optischen Erfassungssystems (16), das eine auf dem Substrat gebildete Markierung beleuchtet, um ein Bild der Markierung zu erfassen, wobei das Verfahren umfasst:
Durchführen einer ersten Verarbeitung zum Erfassen eines Bilds der ersten Markierung (51) unter Verwendung des optischen Erfassungssystems (16), um in einem Zustand, in dem sich die erste Markierung innerhalb eines Sichtfelds (65, 47) des optischen Erfassungssystems befindet, die erste Markierung von der Seite der ersten Oberfläche des Substrats zu beleuchten;
Ändern einer Relativposition des optischen Erfassungssystems in einer Richtung senkrecht zu einer Richtung der optischen Achse des optischen Erfassungssystems und des Substrats über eine Distanz, die gleich groß wie oder größer als die Hälfte eines Durchmessers des Sichtfelds des optischen Erfassungssystems ist, so dass die erste Markierung außerhalb des Sichtfelds des optischen Erfassungssystems angeordnet ist und die zweite Markierung innerhalb des Sichtfelds des optischen Erfassungssystems angeordnet ist;
Durchführen einer zweiten Verarbeitung zum Erfassen eines Bilds der zweiten Markierung (50) unter Verwendung des optischen Erfassungssystems, um in einem Zustand, in dem die erste Markierung (51) sich außerhalb des Sichtfelds des optischen Erfassungssystems befindet und die zweite Markierung (50) sich innerhalb des Sichtfelds des optischen Erfassungssystems befindet, die zweite Markierung von der Seite der ersten Oberfläche des Substrats mit Licht (43) zu beleuchten, das eine Wellenlänge aufweist, die durch das Substrat hindurchgeht; und
Berechnen der Relativposition der ersten Markierung und der zweiten Markierung unter Verwendung von Erfassungsergebnissen der ersten Verarbeitung und der zweiten Verarbeitung.

2. Messverfahren nach Anspruch 1, wobei in der zweiten Verarbeitung ein Produktmuster (59, 60) und die erste Markierung (51), die sich auf der ersten Oberfläche befinden, außerhalb des Sichtfelds (65, 47) des optischen Erfassungssystems (16) liegen.

3. Messverfahren nach Anspruch 1 oder 2, wobei eine Position des Substrats (3) in der Richtung der optischen Achse des optischen Erfassungssystems (16) zwischen der ersten Verarbeitung und der zweiten Verarbeitung geändert wird, so dass das optische Erfassungssystem (16) in der ersten Verarbeitung auf die erste Markierung (51) fokussiert ist und das optische Erfassungssystem in der zweiten Verarbeitung auf die zweite Markierung (50) fokussiert ist.

4. Messverfahren nach Anspruch 1, 2 oder 3, wobei die erste Verarbeitung und die zweite Verarbeitung durchgeführt werden, wenn ein Rotationswinkel des Substrats (3) 0 Grad bzw. 180 Grad um eine Achse einer Normalenrichtung der Substratoberfläche als Rotationsachse beträgt.

5. Messverfahren nach einem der Ansprüche 1 bis 4, ferner umfassend:
in der ersten Verarbeitung und der zweiten Verarbeitung, Erfassen der Relativposition der jeweiligen Markierungen (50, 51) unter Verwendung eines Interferometers (10), das ermöglicht, dass Licht auf einen Spiegel (8) einfällt, der auf einem Tisch (4) bereitgestellt ist, der das Substrat (3) bewegt; und
Erhalten von Korrekturdaten zum Korrigieren eines Erfassungsfehlers der Relativposition der Markierungen (50, 51), der aufgrund einer Änderung einer Position des auf den Spiegel einfallenden Lichts auftritt.

6. Messverfahren nach einem der Ansprüche 1 bis 5, ferner umfassend Erhalten von Versätzen, die für jeweilige Wellenlängen von Licht mit einer ersten Wellenlänge, die nicht durch das Substrat (3) hindurchgeht, das zum Erfassen der ersten Markierung verwendet wird, und Licht mit einer zweiten Wellenlänge, die durch das Substrat hindurchgeht, das zum Erfassen der zweiten Markierung verwendet wird, auftreten; und
Korrigieren eines Erfassungsfehlers der Position der Markierungen basierend auf dem Wellenlängendifferenzversatz.

7. Messverfahren nach Anspruch 6, wobei die Versätze für die jeweiligen Wellenlängen durch Beleuchten einer gleichen Markierung oder zweier identischer Markierungen auf der ersten Oberfläche mit dem Licht mit der ersten Wellenlänge und auf der zweiten Oberfläche mit dem Licht mit der zweiten Wellenlänge erhalten werden.

8. Messverfahren nach Anspruch 3,
wobei in der ersten Verarbeitung Bilder mehrerer erster Markierungen (19), die mehreren auf der ersten Oberfläche des Substrats gebildeten Aufnahmen entsprechen, erfasst werden, ohne die Position des Substrats in der Richtung der optischen Achse (Z) des optischen Erfassungssystems zu ändern, und
wobei in der zweiten Verarbeitung Bilder mehrerer zweiter Markierungen, die mehreren auf der zweiten Oberfläche des Substrats gebildeten Aufnahmen entsprechen, erfasst werden, ohne die Position des Substrats in der Richtung der optischen Achse (Z) des optischen Erfassungssystems zu ändern.

9. Messverfahren nach Anspruch 8, wobei eine Erfassungssequenz der mehreren ersten Markierungen (19) die gleiche ist wie eine Erfassungssequenz der mehreren zweiten Markierungen.

10. Belichtungsverfahren zum Erzeugen von Markierungen auf einem Substrat (3), wobei das Verfahren umfasst:
Bereitstellen eines Substrats, das eine erste Oberfläche und eine zweite Oberfläche gegenüber der ersten Oberfläche umfasst, wobei das Substrat eine auf der zweiten Oberfläche gebildete zweite Markierung umfasst;
Verwenden eines Belichtungssystems, das ein optisches Erfassungssystem umfasst, um auf der ersten Oberfläche des Substrats (3) eine erste Markierung (51) und ein Muster (49, 50) an einer Position auf dem Substrat außerhalb eines Sichtfelds des optischen Erfassungssystems einschließlich einer Position gegenüber der zweiten Markierung zu belichten und zu bilden; und
Ausführen eines Messverfahrens nach einem der vorhergehenden Ansprüche nach dem Belichten und Bilden.

11. Belichtungsverfahren, umfassend:
Berechnen der Relativposition der ersten Markierung (51) und der zweiten Markierung (50) unter Verwendung des Messverfahrens nach einem der Ansprüche 1 bis 9;
Berechnen eines Betrags einer Überlagerungsabweichung der ersten Markierung und der zweiten Markierung unter Verwendung einer Trennung zwischen der ersten Markierung und der zweiten Markierung und der berechneten Relativposition; und
Durchführen einer Ausrichtung des Substrats (3) unter Verwendung des berechneten Betrags der Überlagerungsabweichung.

12. Messvorrichtung zum Messen einer Relativposition zwischen einer auf einer ersten Oberfläche eines Substrats (3) gebildeten ersten Markierung (51) und einer auf einer zweiten Oberfläche gegenüber der ersten Oberfläche des Substrats gebildeten zweiten Markierung (50), wobei die Messvorrichtung umfasst:
ein optisches Erfassungssystem (16), das konfiguriert ist, die auf dem Substrat gebildete Markierung zu beleuchten, um ein Bild der Markierung zu erfassen; und
eine Berechnungseinrichtung, die konfiguriert ist, eine Berechnung unter Verwendung von Erfassungsergebnissen vom optischen Erfassungssystem durchzuführen,
wobei das optische Erfassungssystem (16) konfiguriert ist:
die erste Markierung (51) von der Seite der ersten Oberfläche des Substrats (3) zu beleuchten, um in einem Zustand, in dem sich die erste Markierung innerhalb eines Sichtfelds (65, 47) des optischen Erfassungssystems befindet, das Bild der ersten Markierung zu erfassen, und
ein Bild der zweiten Markierung (50) durch Beleuchten der zweiten Markierung von der Seite der ersten Oberfläche des Substrats mit Licht mit einer Wellenlänge, die durch das Substrat (3) hindurchgeht, unter Verwendung des optischen Erfassungssystems zu erfassen, nachdem eine Relativposition des optischen Erfassungssystems in einer Richtung senkrecht zu einer Richtung der optischen Achse des optischen Erfassungssystems und des Substrats über eine Distanz geändert wurde, die gleich groß wie oder größer als die Hälfte eines Durchmessers des Sichtfelds des optischen Erfassungssystems ist, und
wobei die Berechnungseinrichtung konfiguriert ist, die Relativposition zwischen der ersten Markierung und der zweiten Markierung unter Verwendung von Erfassungsergebnissen vom optischen Erfassungssystem zu berechnen.

13. Computerprogramm, umfassend Anweisungen, um die Vorrichtung nach Anspruch 12 zu veranlassen, das Verfahren nach einem der Ansprüche 1 bis 9 durchzuführen.

14. Belichtungsvorrichtung zum Belichten eines Substrats, umfassend die Messvorrichtung nach Anspruch 12, wobei die Belichtungsvorrichtung konfiguriert ist, eine Ausrichtung des Substrats unter Verwendung einer von der Messvorrichtung berechneten Relativposition zwischen der ersten Markierung (51) und der zweiten Markierung (50) durchzuführen.

15. Verfahren zum Herstellen einer Vorrichtung, umfassend:
Belichten eines Substrats (3) unter Verwendung der Belichtungsvorrichtung nach Anspruch 14; und
Entwickeln des belichteten Substrats.

16. Messverfahren zum Messen einer Relativposition einer auf einer ersten Oberfläche eines Substrats gebildeten ersten Markierung und einer auf einer zweiten Oberfläche gegenüber der ersten Oberfläche des Substrats gebildeten zweiten Markierung unter Verwendung eines optischen Erfassungssystems, das eine auf dem Substrat gebildete Markierung beleuchtet, um ein Bild der Markierung zu erfassen, wobei das Verfahren umfasst:
Durchführen einer ersten Verarbeitung zum Erfassen eines Bilds der zweiten Markierung unter Verwendung des optischen Erfassungssystems, um in einem Zustand, in dem die zweite Markierung innerhalb eines Sichtfelds des optischen Erfassungssystems angeordnet ist, die zweite Markierung von der Seite der ersten Oberfläche des Substrats mit Licht mit einer Wellenlänge zu beleuchten, die durch das Substrat hindurchgeht;
Ändern einer Relativposition des optischen Erfassungssystems in einer Richtung senkrecht zu einer Richtung der optischen Achse des optischen Erfassungssystems und des Substrats über eine Distanz, die gleich groß wie oder größer als die Hälfte eines Durchmessers des Sichtfelds des optischen Erfassungssystems ist, so dass die zweite Markierung außerhalb des Sichtfelds des optischen Erfassungssystems angeordnet ist und die erste Markierung innerhalb des Sichtfelds des optischen Erfassungssystems angeordnet ist;
Durchführen einer zweiten Verarbeitung zum Erfassen eines Bilds der ersten Markierung unter Verwendung des optischen Erfassungssystems, um in einem Zustand, in dem die zweite Markierung außerhalb des Sichtfelds des optischen Erfassungssystems angeordnet ist und die erste Markierung innerhalb des Sichtfelds des optischen Erfassungssystems angeordnet ist, die erste Markierung von der Seite der ersten Oberfläche des Substrats mit Licht zu beleuchten; und
Berechnen der Relativposition der ersten Markierung und der zweiten Markierung unter Verwendung von Erfassungsergebnissen der ersten Verarbeitung und der zweiten Verarbeitung.

17. Messvorrichtung zum Messen einer Relativposition zwischen einer auf einer ersten Oberfläche eines Substrats gebildeten ersten Markierung und einer auf einer zweiten Oberfläche gegenüber der ersten Oberfläche des Substrats gebildeten zweiten Markierung, wobei die Messvorrichtung umfasst:
ein optisches Erfassungssystem, das konfiguriert ist, die auf dem Substrat gebildete Markierung zu beleuchten, um ein Bild der Markierung zu erfassen; und
eine Berechnungseinrichtung, die konfiguriert ist, eine Berechnung unter Verwendung von Erfassungsergebnissen vom optischen Erfassungssystem durchzuführen,
wobei das optische Erfassungssystem konfiguriert ist:
unter Verwendung des optischen Erfassungssystems ein Bild der zweiten Markierung zu erfassen, und zwar durch Beleuchten der zweiten Markierung von der Seite der ersten Oberfläche des Substrats mit Licht mit einer Wellenlänge, die durch das Substrat hindurchgeht, in einem Zustand, in dem die zweite Markierung innerhalb eines Sichtfelds des optischen Erfassungssystems angeordnet ist; und
ein Bild der ersten Markierung zu erfassen, und zwar durch Beleuchten der ersten Markierung mit Licht von der Seite der ersten Oberfläche des Substrats in einem Zustand, in dem eine Relativposition des optischen Erfassungssystems in einer Richtung senkrecht zu einer Richtung der optischen Achse des optischen Erfassungssystems und des Substrats über eine Distanz geändert wird, die gleich groß wie oder größer als die Hälfte eines Durchmessers des Sichtfelds des optischen Erfassungssystems ist, so dass die zweite Markierung außerhalb des Sichtfelds des optischen Erfassungssystems angeordnet ist und die erste Markierung innerhalb des Sichtfelds des optischen Erfassungssystems angeordnet ist, und
wobei die Berechnungseinrichtung konfiguriert ist, die Relativposition zwischen der ersten Markierung und der zweiten Markierung unter Verwendung von Erfassungsergebnissen vom optischen Erfassungssystem zu berechnen.

## Revendications

1. Procédé de mesure pour mesurer une position relative d'un premier repère (51) formé sur une première surface d'un substrat (3) et d'un second repère (50) formé sur une seconde surface opposée à la première surface du substrat en utilisant un système optique de détection (16) qui éclaire un repère formé sur le substrat de façon à détecter une image du repère, le procédé comprenant les étapes consistant à :
exécuter un premier traitement pour détecter une image du premier repère (51) en utilisant le système optique de détection (16) pour qu'il éclaire le premier repère à partir du côté première surface du substrat dans un état dans lequel le premier repère est compris dans un champ de vision (65, 47) du système optique de détection ;
modifier une position relative du système optique de détection dans une direction perpendiculaire à une direction d'axe optique du système optique de détection et du substrat sur une distance supérieure ou égale à un demi-diamètre du champ de vision du système optique de détection, de sorte que le premier repère se trouve en dehors du champ de vision du système optique de détection et que le second repère se trouve dans le champ de vision du système optique de détection ;
exécuter un second traitement pour détecter une image du second repère (50) en utilisant le système optique de détection pour qu'il éclaire le second repère à partir du côté première surface du substrat avec une lumière (43) ayant une longueur d'onde traversant le substrat dans un état dans lequel le premier repère (51) se trouve en dehors du champ de vision du système optique de détection et le second repère (50) se trouve dans le champ de vision du système optique de détection ; et
calculer la position relative du premier repère et du second repère en faisant intervenir des résultats de détection du premier traitement et du second traitement.

2. Procédé de mesure selon la revendication 1, dans lequel, lors du second traitement, un motif de produit (59, 60) et le premier repère (51) qui sont situés sur la première surface se trouvent en dehors du champ de vision (65, 47) du système optique de détection (16).

3. Procédé de mesure selon la revendication 1 ou 2, dans lequel une position du substrat (3) dans la direction d'axe optique du système optique de détection (16) est modifiée entre le premier traitement et le second traitement de sorte que le système optique de détection (16) fasse l'objet d'une mise au point sur le premier repère (51) lors du premier traitement et que le système optique de détection fasse l'objet d'une mise au point sur le second repère (50) lors du second traitement.

4. Procédé de mesure selon les revendications 1, 2 ou 3, dans lequel le premier traitement et le second traitement sont exécutés lorsqu'un angle de rotation du substrat (3) est respectivement de 0 degré et de 180 degrés autour d'un axe d'une direction normale de la surface de substrat en tant qu'un axe de rotation.

5. Procédé de mesure selon l'une quelconque des revendications 1 à 4, comprenant en outre les étapes consistant à :
lors du premier traitement et du second traitement, détecter la position relative des repères respectifs (50, 51) au moyen d'un interféromètre (10) qui permet à une lumière d'être incidente sur un miroir (8) disposé sur une platine (4) qui déplace le substrat (3) ; et
obtenir des données de correction permettant de corriger une erreur de détection de la position relative des repères (50, 51) se produisant du fait d'une modification d'une position de la lumière incidente sur le miroir.

6. Procédé de mesure selon l'une quelconque des revendications 1 à 5, comprenant en outre les étapes consistant à obtenir des décalages qui apparaissent pour des longueurs d'onde respectives d'une lumière ayant une première longueur d'onde qui ne traverse pas le substrat (3) utilisée pour détecter le premier repère et d'une lumière ayant une seconde longueur d'onde traversant le substrat utilisée pour détecter le second repère ; et
corriger une erreur de détection de la position des repères sur la base du décalage de différence de longueur d'onde.

7. Procédé de mesure selon la revendication 6, dans lequel les décalages des longueurs d'onde respectives sont obtenus par éclairement d'un même repère, ou de deux repères identiques, sur la première surface au moyen de la lumière ayant la première longueur d'onde et sur la seconde surface au moyen de la lumière ayant la seconde longueur.

8. Procédé de mesure selon la revendication 3,
dans lequel, lors du premier traitement, des images d'une pluralité de premiers repères (19) correspondant à une pluralité de prises de vue formés sur la première surface du substrat sont détectées sans modifier la position du substrat dans la direction d'axe optique (Z) du système optique de détection, et
dans lequel, lors du second traitement, des images d'une pluralité de seconds repères correspondant à une pluralité de prises de vue formés sur la seconde surface du substrat sont détectées sans modifier la position du substrat dans la direction d'axe optique (Z) du système optique de détection.

9. Procédé de mesure selon la revendication 8, dans lequel une séquence de détection de la pluralité de premiers repères (19) est la même qu'une séquence de détection de la pluralité de seconds repères.

10. Procédé d'exposition pour créer des repères sur un substrat (3), le procédé comprenant les étapes consistant à :
disposer d'un substrat comprenant une première surface et une seconde surface opposée à la première surface, le substrat comprenant un second repère formé sur la seconde surface ;
utiliser un système d'exposition comprenant un système optique de détection pour exposer et former, sur la première surface du substrat (3), un premier repère (51) et un motif (49, 50) au niveau d'une position sur le substrat qui se trouve en dehors d'un champ de vision du système optique de détection comprenant une position opposée au second repère ; et
exécuter un procédé de mesure selon l'une quelconque des revendications précédentes après l'exposition et la formation.

11. Procédé d'exposition comprenant les étapes consistant à :
calculer la position relative du premier repère (51) et du second repère (50) au moyen du procédé de mesure selon l'une quelconque des revendications 1 à 9 ;
calculer une quantité d'écart de recouvrement du premier repère et du second repère en faisant intervenir une séparation entre le premier repère et le second repère et la position relative calculée ; et
exécuter un alignement du substrat (3) en faisant intervenir la quantité calculée d'écart de recouvrement.

12. Appareil de mesure destiné à mesurer une position relative entre un premier repère (51) formé sur une première surface d'un substrat (3) et un second repère (50) formé sur une seconde surface opposée à la première surface du substrat, l'appareil de mesure comprenant :
un système optique de détection (16) configuré pour éclairer le repère formé sur le substrat de façon à détecter une image du repère ; et
un moyen de calcul configuré pour exécuter un calcul faisant intervenir des résultats de détection provenant du système optique de détection,
dans lequel le système optique de détection (16) est configuré :
pour éclairer le premier repère (51) à partir du côté première surface du substrat (3) pour détecter l'image du premier repère dans un état dans lequel le premier repère se trouve dans un champ de vision (65, 47) du système optique de détection, et
pour détecter une image du second repère (50) en éclairant le second repère à partir du côté première surface du substrat avec une lumière ayant une longueur d'onde traversant le substrat (3) au moyen du système optique de détection, après une modification d'une position relative du système optique de détection dans une direction perpendiculaire à une direction d'axe optique du système optique de détection et du substrat sur une distance supérieure ou égale à un demi-diamètre du champ de vision du système optique de détection, et
dans lequel le moyen de calcul est configuré pour calculer la position relative entre le premier repère et le second repère en faisant intervenir des résultats de détection provenant du système optique de détection.

13. Programme informatique comprenant des instructions ayant pour objet d'amener l'appareil selon la revendication 12 à mettre en œuvre le procédé selon l'une quelconque des revendications 1 à 9.

14. Appareil d'exposition destiné à exposer un substrat comprenant l'appareil de mesure selon la revendication 12, l'appareil d'exposition étant configuré pour exécuter un alignement du substrat au moyen d'une position relative, calculée par l'appareil de mesure, entre le premier repère (51) et le second repère (50).

15. Procédé de fabrication d'un dispositif, comprenant les étapes consistant à :
exposer un substrat (3) au moyen de l'appareil exposition selon la revendication 14 ; et
développer le substrat exposé.

16. Procédé de mesure pour mesurer une position relative d'un premier repère formé sur une première surface d'un substrat et d'un second repère formé sur une seconde surface opposée à la première surface du substrat en utilisant un système optique de détection qui éclaire un repère formé sur le substrat de façon à détecter une image du repère, le procédé comprenant les étapes consistant à :
exécuter un premier traitement pour détecter une image du second repère en utilisant le système optique de détection pour qu'il éclaire le second repère à partir du côté première surface du substrat, avec une lumière ayant une longueur d'onde traversant le substrat dans un état dans lequel le second repère se trouve dans un champ de vision du système optique de détection ;
modifier une position relative du système optique de détection dans une direction perpendiculaire à une direction d'axe optique du système optique de détection et du substrat sur une distance supérieure ou égale à un demi-diamètre du champ de vision du système optique de détection, de sorte que le second repère se trouve en dehors du champ de vision du système optique de détection et que le premier repère se trouve dans le champ de vision du système optique de détection ;
exécuter un second traitement pour détecter une image du premier repère en utilisant le système optique de détection pour qu'il éclaire le premier repère à partir du côté première surface du substrat avec une lumière dans un état dans lequel le second repère se trouve en dehors du champ de vision du système optique de détection et le premier repère se trouve dans le champ de vision du système optique de détection ; et
calculer la position relative du premier repère et du second repère en faisant intervenir des résultats de détection du premier traitement et du second traitement.

17. Appareil de mesure destiné à mesurer une position relative entre un premier repère formé sur une première surface d'un substrat et un second repère formé sur une seconde surface opposée à la première surface du substrat, l'appareil de mesure comprenant :
un système optique de détection configuré pour éclairer le repère formé sur le substrat de façon à détecter une image du repère ; et
un moyen de calcul configuré pour exécuter un calcul faisant intervenir des résultats de détection provenant du système optique de détection,
dans lequel le système optique de détection est configuré :
pour détecter une image du second repère en éclairant le second repère, à partir du côté première surface du substrat, avec une lumière ayant une longueur d'onde traversant le substrat au moyen du système optique de détection, dans un état dans lequel le second repère se trouve dans un champ de vision du système optique de détection ; et
pour détecter une image du premier repère en éclairant le premier repère avec une lumière, à partir du côté première surface du substrat, dans un état dans lequel une position relative du système optique de détection dans une direction perpendiculaire à une direction d'axe optique du système optique de détection et du substrat est modifiée sur une distance supérieure ou égale à un demi-diamètre du champ de vision du système optique de détection, de sorte que le second repère se trouve en dehors du champ de vision du système optique de détection et que le premier repère se trouve dans le champ de vision du système optique de détection, et
dans lequel le moyen de calcul est configuré pour calculer la position relative entre le premier repère et le second repère en faisant intervenir des résultats de détection provenant du système optique de détection.
